# EUROPEAN PATENT SPECIFICATION

(11) **EP 1 149 412 B1**
(45) Date of publication and mention of the grant of the patent: **16.05.2007**
(21) Application number: 00903195.6
(22) Date of filing: 07.01.2000
(51) Int. Cl.: H01L 21/312

(54) **DIELECTRIC FILMS FROM ORGANOHYDRIDOSILOXANE RESINS**
DIELEKTRISCHE FILME VON ORGANOHYDRIDOSILOXAN-HARZEN
FILM DIELECTRIQUE FABRIQUE A PARTIR DE RESINES D'ORGANO-HYDRIDOSILOXANE

(30) Priority: 07.01.1999 US 227035; 07.01.1999 US 227498
(43) Date of publication of application: 31.10.2001
(60) Divisional application: 05027397.8
(73) Proprietor: Alliedsignal, Inc., Morristown, NJ 07962-2245 (US)
(72) Inventor: HACKER, Nigel, P., Palo Alto, CA 94201 (US); LEFFERTS, Scott, Sunnyvale, CA 94086 (US); SLESSOR, Michael, D., Campbell, CA 95008 (US); FIGGE, Lisa, K., Menlo Park, CA 94025 (US)
(74) Representative: Viering, Jentschura & Partner
(86) International application number: PCT/US2000/000523
(87) International publication number: WO 2000/041231

(56) References cited:
- EP-A- 0 727 817
- EP-A- 0 750 337
- WO-A-98/47944
- US-A- 5 747 381
- US-A- 5 840 821

## Description

### BACKGROUND

### Field of the Invention

The present invention relates generally to dielectric films obtainable from siloxane based resins and more specifically to low dielectric constant films obtainable from high organic content organohydridosiloxane compositions.

### Related Art

Semiconductor devices often have one or more arrays of patterned interconnect levels that serve to electrically couple the individual circuit elements thus forming an integrated circuit (IC). These interconnect levels are typically separated by an insulating or dielectric film. Previously, a silicon oxide film formed using chemical vapor deposition (CVD) or plasma enhanced CVD (PECVD) techniques was the most commonly used material for such dielectric films. However, as the size of circuit elements and the spaces between such elements decreases, the relatively high dielectric constant of such silicon oxide films is problematic.

EP 0 727 817 A2 describes a dielectric film formed from a modified hydrogen silisequoxane film precursor and methods for producing such films

US 5,747,381 relates to a method of removing residual spin-on-glass (SOG) during planarization step. The SOG layer is deposited by applying the SOG solution at a predetermined spin rate, removing the wafer and placing it to bake successfully on three hot plates and curing the SOG layer.

In order to provide a lower dielectric constant than that of silicon oxide, dielectric films formed from siloxane based resins are becoming widely used. One such family of films formed from siloxane based resins are the films derived from hydrogen silsesquioxane (HSQ) resins (See, U.S. Pat. No. 3,615,272, Oct. 19, 1971, Collins et al.; and U.S. Pat. No. 4,756,977, Jul. 12, 1988, Haluska et al.) However, while such films do provide lower dielectric constants than CVD or PECVD silicon oxide films and also provide other benefits such as enhanced gap filling and surface planarization, it has been found that typically the dielectric constants of such films are limited to approximately 3.0 or greater (See, U.S. Pat. No. 5,523,163, Jun. 4, 1996, Ballance et al.).

Since, as known, the dielectric constant of such insulating films is an important factor where IC's with low power consumption, cross-talk, and signal delay are required, forming an insulating film with a dielectric constant below 3.0 is desirable. As siloxane based resin materials have beneficial gap filling and planarization properties, forming such films from siloxane based resin materials is very desirable. In addition, it would be desirable to have low dielectric constant films formed from siloxane based resin materials which have a high resistance to cracking. Additionally, it would be desirable to manufacture low dielectric constant films from siloxane based resins via standard processing techniques. In this manner curing processes that require an ammonia or ammonia derivative type of atmosphere (See, U.S. Patent No. 5,145,723, Sep. 8, 1992, Ballance et al.), an ozone atmosphere (See, U.S. Patent No. 5,336,532, Haluska et al.), or other non-standard type of semiconductor process, are avoided.

### SUMMARY

In accordance with the present invention, a low dielectric constant insulating film as defined in claim 1 is provided.

The solutions from which the dielectric films in accordance with the present invention are formed, contain organohydridosiloxane resins having one of the four general formulae:

[HSiO_{1.5}]ₙ[RSiO_{1.5}]ₘ; Formula 1

or

[H_{0.4-1.0}SiO_{1.5-1.8}]ₙ[R_{0.4-1.0}SiO_{1.5-1.8}]ₘ Formula 2

or

[H_{0-1.0}SiO_{1.5-2.0}]ₙ[RSiO_{1.5}]ₘ; Formula 3

or

[HSiO_{1.5}]ₓ[RSiO_{1.5}]_{y}[SiO₂]_{z} Formula 4

wherein:
the sum of n and m is from about 8 to about 5000; the sum of x, y and z is from about 8 to about 5000; and R is selected from substituted and unsubstituted groups including normal and branched alkyl groups, cycloalkyl groups, aryl groups, and mixtures thereof.

A specific Mol % of organic or carbon containing substituents in the resins of Formulae 1-4 is a function of the ratio of the amounts of starting materials.

Embodiments used in the present invention employ solutions containing organohydridosiloxane resins having a caged structure. These organohydridosiloxane resins have a polymer backbone encompassing alternate silicon and oxygen atoms. In particular, each backbone silicon atom is bonded to at least three backbone oxygen atoms.

Some embodiments used in accordance with the present invention employ spin coating techniques for application of solutions of the organohydridosiloxane resins. Typically, such resin solutions are approximately 5% to 35% (by weight) resin in an appropriate solvent.

In certain embodiments of the present invention, dielectric films formed from organohydridosiloxane resin solutions by spin coating methods are provided. Such dielectric films advantageously have low dielectric constants of less than 3.0. Films with greater than 40 Mol% organic substituents typically have dielectric constants less than 2.8.

### DETAILED DESCRIPTION

As the present invention is described with reference to various embodiments thereof, it will be understood that these embodiments are presented as examples and not limitations of this invention.

Methods of forming dielectric films from solutions containing organohydridosiloxane resins are provided according to embodiments used in the present invention. The solutions contain organohydridosiloxane resins having one of the four general formulae:

[HSiO_{1.5}]ₙ[RSiO_{1.5}]ₘ; Formula 1

or

[H_{0.4-1.0}SiO_{1.5-1.8}]ₙ[R_{0.4-1.0}SiO_{1.5-1.8}]ₘ; Formula 2

or

[H_{0-1.0}SiO_{1.5-2.0}]ₙ[RSiO_{1.5}]ₘ; Formula 3

or

[HSiO_{1.5}]ₓ[RSiO_{1.5}]_{y}[SiO₂]₂ Formula 4

wherein:
the sum of n and m is from about 8 to about 5000; the sum of x, y and z is from about 8 to about 5000; and R is selected from substituted and unsubstituted groups including normal and branched alkyl groups, cycloalkyl groups, aryl groups, and mixtures thereof; and

The specific Mol % of organic or carbon containing substituents in the resins of Formulae 1-4 is a function of the ratio of the amounts of starting materials. In some embodiments, particularly favorable results are obtained with the mole percent of organic substituents being in the range of between about 40 Mol % to about 80 Mol %. In other embodiments, favorable results are obtained with the mole percent of organic substituents being in the range of between about 5 Mol % to about 25 Mol %. For substituent R a methyl group, these ranges correspond to a carbon content of the organohydridosiloxane resin of between about 8% and about 14%, or between about 1% and about 6% by weight, respectively.

The organohydridosiloxane resins used in making dielectric films, according to embodiments of the present invention, can have molecular weights between about 400 and 200,000 atomic mass units. Preferably the resins have molecular weights between about 1000 and 100,000 atomic mass units, more preferably between about 10,000 and 60,000 atomic mass units, and most preferably between about 20,000 and 40,000 atomic mass units.

The organohydridosiloxane resins used in making the dielectric films are further described in PCT International Applications WO 98/47944 and WO 98/47945, published 29 October 1998.

Methods used in the present invention typically employ spin coating techniques for application of films containing organohydridosiloxane resins. As one of ordinary skill in the art knows, semiconductor substrates are currently available in a variety of sizes ranging from as small as three or four inches (10,25 cm or 15,38 cm) in diameter to as large as twelve inches (30,76 cm) in diameter. Therefore, it will be understood that the process parameters presented hereinafter are for a four inch (10,25 cm or 15,38 cm) or six inch (30,76 cm) wafer and are for illustrative purposes only. Thus, modifications to the volume of material, solution concentration, rotational speeds or the various times described below are appropriate for any specific application.

A solution of organohydridosiloxane resin is prepared by combining the resin with an appropriate solvent. Typically, such resin solutions are approximately 5% to 35% (by weight) resin. Advantageously, methyl isobutyl ketone (MIBK), heptane, dodecane, butyl ether, butyl acetate, isobutyl acetate, propyl acetate or a blend of hexamethyldisiloxane, octamethyltrisiloxane, and octamethylcyclotetrasiloxane, or combinations thereof are useful as solvents, although other appropriate solvents may also be employed. Prior to use, the solvents are preferably dried over 3Å or 4Å molecular sieves.

The resulting solution is then filtered under ambient conditions via any of the filtration devices well known in the art. It is generally preferable to use a filtration device having a pore size less than about 1 µm. A typical filtration process uses a pore size of about 0.1 µm.

In the spin coating process, the organohydridosiloxane resin solution prepared in the manner described above is dispensed onto a wafer at or near its center. In some embodiments, the wafer will remain stationary during the dispense cycle, while in some embodiments, the wafer will turn or spin at a relatively low speed, typically less than about 500 revolutions per minute (rpm). The dispense cycle is followed by a short rest period and then additional spins, hereinafter referred to as thickness spins, generally between approximately 2000 and 3000 rpm, although other spin speeds may be used, as appropriate.

Once the coating process, as described above, is completed, the coated substrate, that is the substrate coated with the resin solution, is heated to effect a bake process and a subsequent cure process. The bake process removes the solvent from the resin solution on the substrate, causes the polymer to flow, and begins the conversion of the coating to the dielectric film. The cure process completes the conversion of the coating to the dielectric film. Any conventional apparatus known in the art can be employed for these processes.

Preferably, the apparatus for the bake process is an integral part of a spin coating apparatus used for coating the substrate or wafer, although a separate apparatus for curing coatings applied in accordance with embodiments of the present invention is also suitable. The bake process can be carried out in an inert atmosphere such as an atmosphere of an inert gas, nitrogen, or nitrogen/air mixture. One commonly employed heating apparatus employs one or more "hot plates" to heat the coated wafer from below. The coated wafer is typically heated for up to about 120 sec at each of several hot plates at successively higher temperatures. Typically, the hot plates are at temperatures between about 70°C and 350°C. One typical process employs a heating apparatus having three hot plates. First, the wafer is baked for about 60 sec at 150°C. Then the wafer is transferred to a second hot plate for an approximately 60 sec bake period at 200°C. Finally, the wafer is transferred to a third hot plate for a third bake period of approximately 60 sec at 350°C.

A final cure process is preferably employed to complete the curing of the film. The cure is preferably performed in an inert atmosphere, as described above for the bake process. This final cure process can employ a conventional thermal curing apparatus, for example a horizontal furnace with a temperature range of about 300°C to about 450°C and preferably from about 375°C to about 425°C. In a typical furnace cure process, the baked wafer is cured for 30 minutes to one hour at 400°C at a nitrogen flow rate of 4 liters/min to 20 liters/min.

Alternatively, the cure process can employ a high-temperature hot plate curing module which has an oxygen-density-controlled environment. In this process, the baked wafer is cured on a hot plate at a temperature between about 400°C and 450°C for a period of from about 1 to about 15 minutes in a nitrogen or inert atmosphere with an oxygen density of less than about 100 parts per million. For example, a suitable cure atmosphere is achieved with a nitrogen flow rate of between about 10 and about 30 liters/min.

It will be understood that the above bake and cure processes were described for illustrative purposes only and that other temperatures, durations, and number of bake cycles can be employed, where appropriate.

The thickness of the resulting dielectric film on a substrate depends on a number of variables. The variables include, organic content of the organohydridosiloxane resin, type of substituent in the resin, solvent properties, resin molecular weight, percentage of the resin solids in the resin solution, the amount of resin solution dispensed onto the substrate, and the speed of the thickness spin. The higher the percentage of resin solids in the solution, the thicker the resulting dielectric film. Conversely, the higher the speed of the thickness spin, the thinner the resulting dielectric film. In addition, the thickness of the dielectric film can depend on the nature and amount of the organic constituents in the organohydridosiloxane resin.

According to embodiments of the present invention, dispensing 2 ml of resin solution that is between about 5 % and about 35 % resin by weight on a 4 inch (10,25 cm) wafer, using a spin speed between about 2000 and about 3000 rpm, results in dielectric films ranging from about 1000 Å to about 9000 Å in thickness. Variation in thickness, determined by independent measurements on a single wafer, ranges from about 0.4 % to 1%.

In certain embodiments of the present invention, dielectric films formed from organohydridosiloxane resin solutions by spin coating methods are provided. The dielectric films are formed from solutions of organohydridosiloxane resins having a mole percent of organic substituents preferably in the range between about 40 Mol % and about 80 Mol %.and in the range between about 5 Mol % and about 35 Mol %. As demonstrated in the examples below, such dielectric films exhibit low dielectric constants, of 3.0 or lower. In addition, the films exhibit adhesion to semiconductor substrates of greater than about 8 kpsi (55,158 MPa).

The following characteristics encompass nonlimiting measurements that illustrate the properties of films of organohydridosiloxane polymer resins of the present invention. The methods of measurement used are as follows:
1) Film Thickness (A) : Film thickness is measured using a calibrated Nanospec® AFT-Y CTS-102 model 010-180 Film Thickness Measurement System available from Nanometrics, Co. An average of measurements at five locations on a wafer are reported as the film thickness for each sample. Thickness measurements are corrected for the refractive index as measured on a Rudolph ellipsometer.
2) Refractive Index: Refractive index is measured on a Rudolph Research AutoEL ellipsometer using a wavelength of 633.3 nm.
3) Dielectric Constant: Dielectric constant is determined using the capacitance-voltage ("CV") measurement technique and employs a Hewlett-Packard Model 4061A semiconductor measurement system at a frequency of 1 MHz. This test procedure employs a metal-insulator-metal (MIM) structure with the thickness of each layer ranging from about 0.5 to 1 micron (µm).
4) Solution Viscosity (cP) : A Brookfield Synchro-lectric Viscometer, Model LVT 62238 is employed to measure the viscosity of organohydridosiloxane resin solutions at ambient temperature.
5) Isothermal TGA : Cured films are carefully removed from the wafers, heated to 100°C and held for one hour to equilibrate before recording initial weight. The instrument is then ramped from 100°C to 425°C at 25°C per minute (under nitrogen atmosphere) and held at 425°C for four hours to determine percent weight loss.
6) Planarization: Polymer films are spun on silicon wafers patterned with line and space patterns of varying widths (0.35 - 3.0 µm). The wafers are baked and cured using the appropriate recipe. The cured wafers are then cleaved horizontally across the pattern of lines and this cross-section is examined using a scanning electron microscope (SEM). The degree of planarization for a particular line and space width is calculated by measuring the ratio of the highest point of the film versus the lowest point.
7) Stress: Film stress is measured using a Flexus^{™} model 2410 Film Stress Measurement System available from Tencor Instruments using standard methods.
8) Crack Threshold: A single coat film is spun, baked, and cured on a bare silicon wafer using the appropriate recipe in 1000Å thickness increments. The wafers are examined 24-48 hrs following cure to check for cracking.

### Example 1

Methyl isobutyl ketone (MIBK) (127.4 g) was dried over 4Å molecular sieves and combined with 28 g of 80 Mol % methylhydridosiloxane resin, which contains approximately 14% carbon, as measured by Rutherford back scattering, to form an 18 weight % resin solution. The solution was filtered to 0.2 µm. The solution was coated on a bare 4 inch (10,25 cm) silicon wafer using a conventional spin coater. Approximately 3 ml of the polymer solution was placed on the wafer. After a 3 second delay, the wafer was spun at 2000 rpm for 20 seconds. The coated wafer was baked on three successive hot plates for one minute each at 150°C, 200°C, and 350°C, respectively. The baked wafer was then cured in a nitrogen atmosphere in a horizontal furnace set initially at 300°C, followed by a ramp to 380°C at a rate of 4°C/minute, where it was held for 10 minutes, then increased to 400°C at a rate of 1°C/minute. The furnace temperature was held at 400°C for one hour and then lowered back to 300°C over a period of about 2 hours. Film thickness for Examples 1-6, determined after the bake step and determined again after the cure step, corrected for refractive index, is given below in Table 1.

### Example 2 (not belonging to the invention as claimed)

A siloxane solvent blend (hexamethyldisiloxane, octamethyltrisiloxane, and octamethylcyclotrisiloxane) (57.4 g) was dried over 4Å molecular sieves and combined with 12.6 g of 80 Mol % methylhydridosiloxane resin to form an 18 weight % resin solution. The solution was filtered to 0.2 µm. Approximately 3 ml of the polymer solution was placed on a bare 4 inch (10,25 cm) silicon wafer. After a 3 second delay, the wafer was spun at 3000 rpm for 20 seconds. The coated wafer was baked on three successive hot plates for one minute each at 150°C, 200°C, and 350°C, respectively. The baked wafer was then cured in a nitrogen atmosphere in a horizontal furnace set initially at 300°C, followed by a ramp to 360°C at a rate of 4°C/minute, where it was held for 5 minutes, then increased to 380°C at a rate of 1°C/minute. The furnace temperature was held at 380°C for 30 minutes and then lowered back to 300°C over a period of about 2 hours.

### Example 3 (not belonging to the invention as claimed)

The siloxane solvent blend as in Example 2 (661.5 g) was dried over 4Å molecular sieves and combined with 238.5 g of 80 Mol % methylhydridosiloxane resin to form a 26.5 weight % resin solution. The solution was filtered to 0.1 µm. The solution was dispensed on a silicon wafer, which was spun, baked, and cured as in Example 2.

### Example 4

40 Mol % methylhydridosiloxane resin (14 g), which contains approximately 9% carbon, as measured by Rutherford back scattering, was combined with MIBK solvent (63.7 g) to form an 18 weight % resin solution. The solution was dispensed on a silicon wafer, which was spun and baked as in Example 1. The baked wafer was then cured in a nitrogen atmosphere in a furnace set initially at 300°C followed by a ramp to 400°C at a rate of 4°C/minute, held at 400°C for one hour and then lowered back to 300°C over a period of about 2 hours.

### Example 5

60 Mol % methyl/20 Mol % benzyl hydridosiloxane resin was combined with MIBK solvent to form an 18 weight % resin solution. The solution was dispensed on a silicon wafer, which was spun and baked as in Example 1. The baked wafer was then cured in a nitrogen atmosphere in a furnace set initially at 300°C followed by a ramp to 380 °C at a rate of 4°C/minute, held at 400°C for one hour and then lowered back to 300°C over a period of about 2 hours.

### Example 6

60 Mol % methyl/20 Mol % chloromethyl hydridosiloxane resin was combined with MIBK solvent to form an 18 weight % resin solution. The solution was dispensed on a silicon wafer, which was spun, baked, and cured as in Example 5.

**TABLE 1. THICKNESS OF FILMS FROM EXAMPLES 1-6**

| Example | Baked Thickness (Å) | Baked Non-Uniformity | Cured Thickness (Å) | Cured Non-Uniformity |
|---|---|---|---|---|
| Example 1 | 4202 | 0.4% | 4304 | 0.8% |
| Example 2* | 3911 | 1.6% | 4032 | 1.1% |
| Example 3* | 9129 | 1.0% | 9535 | 1.3% |
| Example 4 | 4575 | 0.4% | 4755 | 0.7% |
| Example 5* | 4493 | | 4595 | |
| Example 6* | 3545 | | 3720 | |

| | | | | |
|---|---|---|---|---|
| * not belonging to the invention as claimed | | | | |

### Example 7

An 18 weight % resin solution of an 80 Mol % methylhydridosiloxane resin in a variety of solvents was spun and baked as described in Example 4. The film thickness after bake, corrected for the refractive index is given below in Table 2.

**TABLE 2. THICKNESS OF FILMS OF 80 MOL % METHYLHYDRIDOSILOXANE RESIN IN DIFFERENT SOLVENTS**

| Solvent | Refractive Index | Film Thickness (Å) |
|---|---|---|
| Acetone | 1.437 | 7580 |
| Cyclohexanone | 1.391 | 4380 |
| Cyclopentanone | 1.399 | 4865 |
| 1,2 dimethoxy propane (DMP) | 1.361 | 8517 |
| MIBK | 1.395 | 4352 |

### Example 8

Resin solutions of 80 Mol % methylhydridosiloxane resin in the siloxane solvent were prepared by the methods of Example 2 (18 weight % resin) and Example 3 (26.5 weight % resin). The solutions were dispensed on a wafer, spun for 20 seconds at speeds between 1000 and 5000 rpm, and baked as given in Examples 2 and 3. Thickness after bake as a function of spin speed is given below in Tables 3 and 4.

**TABLE 3. THICKNESS OF FILMS OF 80 MOL % METHYLHYDRIDOSILOXANE RESIN IN SILOXANE SOLVENT (18% RESIN) AS FUNCTION OF SPIN SPEED**

| Speed (RPM) | Baked Thickness (Å) | Baked Non-Uniformity (%) |
|---|---|---|
| 1000* | 7454 | 3.5 |
| 2000* | 4994 | 1.5 |
| 3000 | 4037 | 0.5 |
| 4000 | 3480 | 0.7 |
| 5000 | 3162 | 1.0 |

| | | |
|---|---|---|
| *not belonging to the invention as claimed | | |

**TABLE 4. THICKNESS OF FILMS OF 80 MOL % METHYLHYDRIDOSILOXANE RESIN IN SILOXANE SOLVENT (26.5% RESIN) AS FUNCTION OF SPIN SPEED**

| Speed (RPM) | Baked Thickness (Å) | Baked Non-Uniformity (%) |
|---|---|---|
| 1000 | 16289 | 3.2* |
| 2000 | 10784 | 3.2* |
| 3000 | 8821 | 2.8* |
| 4000 | 7606 | 1.3* |
| 5000 | 6620 | 0.6 |

| | | |
|---|---|---|
| * not belonging to the invention as claimed | | |

### Example 9

Viscosity of solutions of 80 Mol % methylhydridosiloxane resin in different solvents are given below in Table 5.

**TABLE 5. VISCOSITY OF SOLUTIONS OF 80 mol % METHYLHYDRIDOSILOXANE RESIN**

| Solvent | % solids | Viscosity (cP) |
|---|---|---|
| MIBK | 19 | 1.72 |
| MIBK | 30.0 | 3.24 |
| Siloxane blend | 18 | 5.11 |
| Siloxane blend | 26.5 | 10.86 |

### Example 10

Properties of the dielectric films of Examples 1 and 4 are given below in Table 6.

**TABLE 6. PROPERTIES OF DIELECTRIC FILMS**

| Property | Example 1 | Example 4 |
|---|---|---|
| Dielectric constant MIM parallel plate, 1 Mhz | 2.5 | 2.8 |
| Refractive index (film cured at 400 °C) | 1.37 | 1.356 |
| Stress | (50 kpsi) 344,74 MPa | 84 kpsi |
| Isothermal Weight loss @ 425 °C, 4 hr | 0.3%/hr | Not measured |
| Planarization over a 1µm line and space pattern | 91% | Not measured |
| Crack threshold | 1 µm | Not measured |

### Example 11

Methyl isobutyl ketone (MIBK) (2000.1g) was dried over 4Å molecular sieves and combined with 501.1g of 20 mol% methylhydridosiloxane resin, which contains approximately 4% to 5% carbon, as measured by Rutherford back scattering, to form a solution. The solution was filtered to 0.1 µm. The solution was coated on six bare silicon wafers using a conventional spin coater. After a 3 second delay, the wafers were spun at speeds ranging from 1000 to 6000 rpm for 20 seconds. Acceleration before the thickness spin and deceleration afterwards were both at a rate of 50,000 rpm/sec. The wafers were baked on three successive hot plates for one minute each at 150°C, 200°C, and 350°C, respectively. The wafers were cured at 400°C for 45 minutes in a horizontal furnace under a nitrogen atmosphere at a flow rate of 14 liters/min. Film thickness as a function of spin speed, determined after the bake step and determined again after the cure step, corrected for refractive index, is given below in Table 7.

**TABLE 7. THICKNESS OF FILMS FROM SOLUTIONS OF METHYLHYDRIDOSILOXANE RESIN CONTAINING 4-5% CARBON**

| Speed (RPM) | Baked Thickness (Å) | Baked Non-Uniformity | Cured Thickness (Å) | Cured Non-Uniformity |
|---|---|---|---|---|
| 1000 | 6936 | 1.0% | 7248 | 0.9% |
| 2000 | 4794 | 0.4% | 5061 | 0.4% |
| 3000 | 3927 | 0.08% | 4132 | 0.4% |
| 4000 | 3426 | 0.4% | 3616 | 0.7% |
| 5000 | 3048 | 0.3% | 3208 | 0.5% |
| 6000 | 2735 | 0.2% | 2888 | 0.8% |

### Example 12

Methyl isobutyl ketone (MIBK) (30.5g) was dried over 4Å molecular sieves and combined with 10.5g of 20 mol% methylhydridosiloxane resin, which contains approximately 4% to 5% carbon to form a solution. The solution was filtered to 0.2 µm. The solution was coated on a bare silicon wafer using a spin coater. After a 3 second delay, the wafers were spun at 3000 rpm for 20 seconds. Acceleration before the thickness spin and deceleration afterwards were both at a rate of 50,000 rpm/sec. The wafer was baked on three successive hot plates for one minute each at 150°C, 200°C, and 350°C, respectively. Film thickness on the wafer averaged 5907Å, corrected for the refractive index of 1.4. Thickness varied by 0.5% over 5 measurements. The wafer was cured at 400°C for 30 minutes in a horizontal furnace under a nitrogen atmosphere at a flow rate of 14 liters/min. Thickness after curing averaged 6178Å, corrected for the refractive index of 1.366. Thickness varied by 0.4% over 5 measurements.

### Example 13

Viscosity of the solutions of Examples 11 and 12, is given below in Table 8.

**TABLE 8. VISCOSITY OF SOLUTIONS OF METHYLHYDRIDOSILOXANE RESIN CONTAINING 4-5% CARBON**

| Example | % solids | Viscosity (cP) |
|---|---|---|
| Example 1 | 20.0 | 1.26 |
| Example 2 | 25.7 | 1.80 |

### Example 14

Polymer solutions were prepared according to the methods of Example 11, using the percentages of methyl subtituent in the methylhydridosiloxane resin listed in Table 9, below. Films were prepared by spinning the polymer solutions onto 6 inch (15,38 cm) silicon wafers with a 6000 Å film of silane oxide deposited on the surface. The spin, bake and cure conditions used were identical to those described in Example 12. Each wafer was cleaved into 15 samples and the adhesion to each sample was measured by the stud pull test in the manner previously described. The values reported are the average of 15 samples tested for each film. In most cases, the adhesion failure occurs at the stud/epoxy interface, which suggests the adhesion at the film/substrate interface is greater than the values reported below.

**TABLE 9. STUD PULL VALUES FOR FILMS WITH DIFFERENT PER CENT METHYL SUBSTITUENTS**

| Mol % Methyl | Stud pull value (kpsi) MPa |
|---|---|
| 0 | (9.5) 65,50 |
| 5 | (9.2) 63,43 |
| 10 | (8.6) 59,29 |
| 15 | (8.8) 60,67 |
| 20 | (9.6) 66,19 |

### Example 15

Methyl isobutyl ketone (MIBK) (63.8g) was dried over 4Å molecular sieves and combined with 14.0 g of 20 mol% methylhydridosiloxane resin, which contains approximately 4% to 5% carbon to form a solution. The solution was filtered to 0.2 µm. The solution was coated on two bare silicon wafers using a spin coater. After a 3 second delay, the wafers were spun at 2000 rpm for 20 seconds. Acceleration before the thickness spin and deceleration afterwards were both at a rate of 50,000 rpm/sec. The wafer were baked on three successive hot plates for one minute each at 150°C, 180°C, and 300°C, respectively. Film thickness on the two wafers averaged 4550Å, corrected for the refractive index of 1.403. Thickness varied by < 0.7% over 5 measurements on each of two wafers. The wafers were cured at 400°C for one hour in an horizontal furnace under a nitrogen atmosphere at a flow rate of 4 liters/min. Thickness after curing averaged 4688Å, corrected for the refractive index of 1.366. Thickness varied by < 1.4% over 5 measurements on each of the two wafers. The dielectric constant of the film after curing was 3.04.

### Examples 16 through 20

Examples 16 through 20 describe the process of making dielectric films from organohydridosiloxane resins of different organic substituents. The same process of forming a solution, filtering, dispensing, spinning, baking, and curing, as described in Example 15 above was used. One bare silicon wafer was coated in each of Examples 16 through 20. Reported thickness values are the average of five measurements on a single wafer. Results are summarized in Tables 10 and 11, below.

**TABLE 10. SOLUTIONS OF ORGANOHYDRIDOSILOXANE RESINS**

| Example | Mol% organic substituent | % carbon | resin (g) | solvent (g) | weight % resin |
|---|---|---|---|---|---|
| Example 15 | 20% methyl | 4-5 | 14.0 | MIBK | 18.0 |
| | | | | 63.8 | |
| Example 16 | 20% ethyl | 5-8 | 14.0 | MIBK | 18.0 |
| | | | | 63.7 | |
| Example 17 | 20% propyl | 8-12 | 26.8 | MIBK | 18.2 |
| | | | | 120.2 | |
| Example 18 | 20% n-butyl | 10-14 | 13.97 | MIBK | 17.9 |
| | | | | 64.2 | |
| Example 19 | 20% cyclohexyl | 15-20 | 14.5 | Siloxane* | 18.0 |
| | | | | 66.0 | |
| Example 20 | 20% phenyl | 15-20 | 9.0 | MIBK | 17.9 |
| | | | | 41.2 | |

| | | | | | |
|---|---|---|---|---|---|
| * Blend of hexamethyldisiloxane, octamethyltrisiloxane, and octamethylcyclotetrasiloxane | | | | | |

**TABLE 11. PROPERTIES OF DIELECTRIC FILMS**

| Example | Thickness before cure (Å) | Variation (%) | Thickness after cure (Å) | Variation (%) | Dielectric Constant |
|---|---|---|---|---|---|
| Example 15* | 4550 | 0.93 | 4688 | 1.8 | 3.04 |
| Example 16* | 4775 | 0.90 | 4965 | 2.5 | 2.97 |
| Example 17* | 3350 | 1.2 | 3063 | | 2.86 |
| Example 18* | 4416 | 0.37 | 4144 | 1.4 | 2.86 |
| Example 19* | 4337 | 3.1 | 4171 | 5.3 | 3.03 |
| Example 20 | 4786 | 0.58 | 5054 | 0.51 | 2.82 |

| | | | | | |
|---|---|---|---|---|---|
| * not belonging to the invention as claimed | | | | | |

As it can be seen, dielectric constants for films according to the present invention were approximately 3.0 or lower. Films with greater than 40 Mol% organic substituents typically have dielectric constants less than 2.8. These values may be compared with the dielectric constant of a film of a previously known hydridosiloxane resin with no organic substituents, cured at 400°C which exhibits a dielectric constant of 3.27. In view of the foregoing, it will be understood that the present invention provides dielectric films of organohydridosiloxane resins. These films are advantageously used in semiconductor devices as insulating materials with low dielectric constants. It will be understood the methods of preparing dielectric films used in the invention employ standard processing techniques of semiconductor fabrication, avoiding use of ammonia, ozone, or other non-standard atmospheres.

## Claims

1. A dielectric film formed on a substrate, said dielectric film having a thickness variation over a single substrate of less than 1% and a dielectric constant of less than 3, said dielectric film being obtainable by the following method:
forming a solution of a solvent and an organohydridosiloxane resin comprising a polymer having a general formula:
[HSiO_{1,5}]ₙ[RSiO_{1,5}]ₘ,
or
[H_{0.4-1.0}SiO_{1.5-1.8}]ₙ[R_{0.4-1.0}SiO_{1.5-1.8}]ₘ,
or
[H_{0.1-1.0}SiO_{1.5-2.0}]ₙ[RSiO_{1.5}]ₘ,
or
[HSiO_{1.5}]ₓ[RSiO_{1.5}]_{y}[SiO₂]_{z},
wherein the sum of n and m is from about 8 to about 5000, the sum of x, y, and z is from about 8 to about 5000, and R, in any general formula, is selected from substituted and unsubstituted normal and branched alkyl groups, cycloalkyl groups, substituted and unsubstituted aryl groups, and mixtures thereof, wherein the organohydridosiloxane resin has a cage conformation;
dispensing the solution,on the substrate;
spinning the substrate to form an organohydridosiloxane resin coated substrate;
baking the organohydridosiloxane resin coated substrate at least two times to remove any residual solvent, cause the polymer to flow, and partially convert the resin to the dielectric film wherein each baking step is at a higher temperature than the proceeding step; and
curing the organohydridosiloxane resin coated substrate, wherein the conversion to the dielectric film is completed.

## Patentansprüche

1. Ein auf einem Substrat gebildeter dielektrischer Film, wobei der dielektrische Film eine Variation der Dicke gegenüber einem einzelnen Substrat von weniger als 1% und eine dielektrische Konstante von weniger als 3 aufweist, wobei der dielektrische Film durch das folgende Verfahren erhältlich ist:
Bilden einer Lösung aus einem Lösungsmittel und einem Organohydrosiloxanharz, das ein Polymer der allgemeinen Formel umfasst:
[HSiO_{1,5}]ₙ[RSiO_{1,5}]ₘ,
oder
[H_{0,4-1,0}SiO_{1,5-1,8}]ₙ[R_{0,4-1,0}SiO_{1,5-1,8}]ₘ,
oder
[H_{0,1-1,0}SiO_{1,5-2,0}]ₙ[RSiO_{1,5}]ₘ,
oder
[HSiO_{1,5}]ₓ[RSiO_{1,5}]_{y}[SiO₂]_{z},
wobei die Summe von n und m bei etwa 8 bis etwa 5000, die Summe von x, y und z von etwa 8 bis etwa 5000 liegt, und R in jeder allgemeinen Formel aus substituierten und
unsubstituierten normalen und verzweigten Alkyl-Gruppen, Cykloalkyl-Gruppen, substituierten und unsubstituierten ArylGruppen und Mischungen davon ausgewählt wird, wobei das Organohydrosiloxanharz eine Käfigkonformation aufweist;
Dispensieren der Lösung auf dem Substrat;
Schleudern des Substrates, um ein mit Organohydrosiloxanharz beschichtetes Substrat zu bilden; mindestens zweimaliges Brennen des mit Organohydrosiloxanharz beschichteten Substrats, um das gesamte restliche Lösungsmittel zu entfernen, was das Fließen des Polymers und die teilweise Umwandlung des Harzes in den dielektrischen Film verursacht, wobei jeder Brennvorgang bei einer höheren Temperatur stattfindet als der vorhergehende Vorgang; und
Aushärten des mit Organohydrosiloxanharz beschichteten Substrates, wobei die Umwandlung des dielektrischen Films abgeschlossen wird.

## Revendications

1. Film diélectrique formé sur un substrat, ledit film diélectrique présentant une variation d'épaisseur sur un seul substrat inférieure à 1 % et une constante diélectrique inférieure à 3, ledit film diélectrique étant susceptible d'être obtenu par un procédé comprenant les étapes suivantes :
- former une solution d'un solvant et d'une résine organohydridosiloxane comprenant un polymère répondant à la formule générale :
[HSiO_{1,5}]ₙ[RSiO_{1,5}]ₘ,
ou
[H_{0,4-1,0}SiO_{1,5-1,8}]ₙ[R_{0,4-1,0}SiO_{1,5-1,8}]ₘ,
ou
[H_{0,1-1,0}SiO_{1,5-2,0}]ₙ[RSiO_{1,5}]ₘ,
ou
[HSiO_{1,5}]ₓ[RSiO_{1,5}]_{y}[SiO₂]_{z},
dans laquelle la somme de n et m a une valeur d'environ 8 à environ 5000, la somme de x, y et z a une valeur d'environ 8 à environ 5000, et R, dans l'une quelconque des formules générales, est choisi parmi des groupes alkyle normaux et ramifiés, substitués et non substitués, des groupes cycloalkyle, des groupes aryle substitués et non substitués, et leurs mélanges, la résine organohydridosiloxane ayant une conformation de cage ;
- répartir la solution sur le substrat ;
- faire tourner le substrat pour former un substrat revêtu de résine organohydridosiloxane ;
- cuire au moins deux fois le substrat revêtu de résine organohydridosiloxane pour éliminer tout solvant résiduel, provoquer l'écoulement du polymère, et transformer partiellement la résine en le film diélectrique, chaque étape de cuisson ayant lieu à une température supérieure à celle de l'étape précédente ; et
- durcir le substrat revêtu de résine organohydridosiloxane, étape au cours de laquelle la transformation en film diélectrique est achevée.
